# EUROPEAN PATENT APPLICATION

(11) **EP 2 944 395 A1**
(43) Date of publication of application: **18.11.2015**
(21) Application number: 13870669.2
(22) Date of filing: 25.12.2013
(51) Int. Cl.: B21J 5/06, B21D 53/02, H01L 23/473

(54) **METHOD FOR PRODUCING COOLING DEVICE AND HEAT-DISSIPATING MEMBER**

(30) Priority: 11.01.2013 JP 2013003713
(71) Applicant: Futaba Industrial Co. Ltd., Okazaki-shi, Aichi 444-8558 (JP)
(72) Inventor: TANAKA, Yoshiki, Okazaki-shi Aichi 444-8558 (JP); TAKEMOTO, Naohiro, Okazaki-shi Aichi 444-8558 (JP); ISHIMARU, Yuki, Okazaki-shi Aichi 444-8558 (JP); ISHIKAWA, Daisuke, Okazaki-shi Aichi 444-8558 (JP)
(74) Representative: Otten, Roth, Dobler & Partner mbB Patentanwälte
(86) International application number: PCT/JP2013/084723
(87) International publication number: WO 2014/109235

(57) **Abstract**

In the method for producing a heat-dissipating member of the present invention, the heat-dissipating member having a plurality of heat dissipation fins and lateral walls is produced by using a forging method such as impact molding. The producing method comprises: positioning a metal material on a lower die provided with projections corresponding to positions at which the plurality of heat dissipation fins and lateral walls to be provided in the heat-dissipating member are to be formed; and molding the metal material by pressing an upper die having recesses for molding the heat dissipation fins and lateral walls against the lower die on which the metal material is positioned, in a manner such that the recesses correspond to the projections on the lower die.

## Description

### CROSS-REFERENCE TO RELATED APPLICATIONS

This international application claims the benefit of Japanese Patent Application No. 2013-3713 filed January 11, 2013 in the Japan Patent Office, and the entire disclosure of Japanese Patent Application No. 2013-3713 is incorporated herein by reference.

### TECHNICAL FIELD

The present invention relates to a cooling device for cooling electronic components provided in an automobile or the like, and to a method for producing a heat-dissipating member constituting the cooling device.

### BACKGROUND ART

An automobile such as an electric vehicle and a hybrid vehicle is equipped with heat generating devices such as a battery and a driving motor control device, or with heating elements such as a CPU, a GPU and an inverter mounted on a computer. Thus, the automobile carries a heat sink (cooling device) for cooling the heat generating devices and the heating elements.

An example of the heat sink used for cooling electronic components is shown in Patent Document 1, for example. The heat sink shown in Patent Document 1 comprises inner fins (heat dissipation fins), for the purpose of increasing a heat transfer area so as to improve cooling capability.

For molding a heat sink comprising such inner fins, impact molding as described in Patent Document 2, for example, can be used. Impact molding, is a type of forging (more specifically, cold forging), and is a method of molding a metal component by utilizing a behavior of material (slag) reaching up along a punch, which is caused by an impact on the slag with the punch. Therefore, molding a heat sink using impact molding allows short time processing with a small number of steps, as compared to cutting or extrusion molding.

### PRIOR ART DOCUMENTS

### PATENT DOCUMENTS

Patent Document 1: Japanese Unexamined Patent Application Publication No. 2008-171840
Patent Document 2: Japanese Unexamined Patent Application Publication No. 2007-275956

### SUMMARY OF THE INVENTION

### PROBLEMS TO BE SOLVED BY THE INVENTION

In a case of molding a heat sink using a forging method such as impact molding, however, slag may not sufficiently spread into a molding die. It is possible that molding defects may occur in heat dissipation fins.

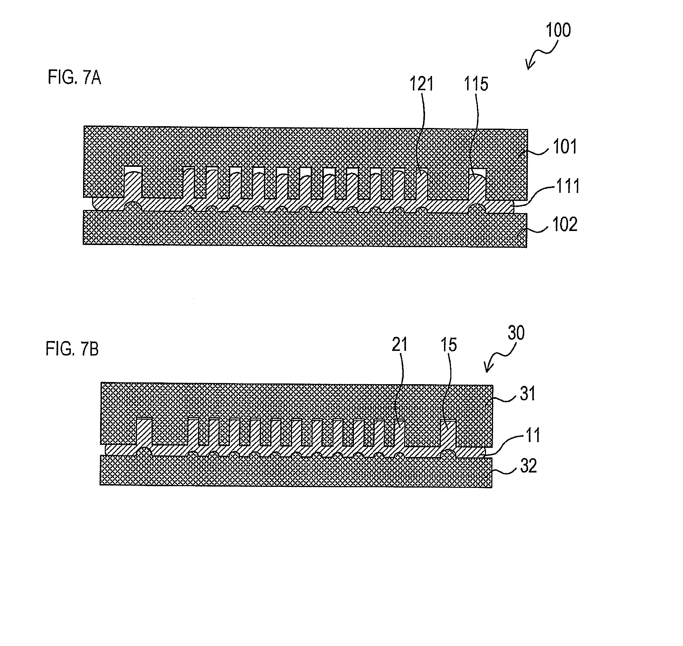

Explanation on the above problem will be given with reference to FIG. 7A. FIG. 7A shows how to mold a heat-dissipating member 111 that constitutes a heat sink by impact molding, using a mold 100 (upper die 101 and lower die 102) conventionally used for impact molding. As shown in FIG. 7A, when the heat-dissipating member 111 is molded using the conventional mold 100, slag is less likely to spread into distal ends of recesses for molding heat dissipation fins 121 and lateral walls 115 provided in the upper die 101. This is because, when the upper die 101 is pressed with the slag positioned on the lower die 102, a large amount of the slag for the volume of the recesses flows in toward the recesses for molding the heat dissipation fins 121, etc., so that the slag ends up staying near the entrance of the recesses. When such staying of the slag occurs, the slag hardly flows into the recesses, and does not sufficiently spread into the distal ends of the recesses. As a result, the molded heat dissipation fins 121 may not have a sufficient height, and a desired heat dissipation performance may not be achieved.

In one aspect of the present invention, it is desirable to provide a method for producing a heat-dissipating member that improves cooling capacity of a cooling device, and a cooling device that has improved cooling capacity.

### MEANS FOR SOLVING THE PROBLEMS

A method for producing a heat-dissipating member of the present invention may use impact molding. The method may comprise: positioning a metal material on a lower die provided with projections corresponding to positions at which projecting portions to be provided in the heat-dissipating member are to be formed; and molding the metal material by: pressing an upper die having recesses for molding the projecting portions against the lower die on which the metal material is positioned, in a manner such that the recesses correspond to the projections on the lower die.

According to the method for producing a heat-dissipating member of the present invention, since the projecting portions are positioned on the lower die corresponding to the positions at which the projecting portions, such as the heat dissipation fins and the lateral walls, provided in the heat-dissipating member are to be formed, it is possible to spread the metal material to distal ends of the recesses for molding the projecting portions upon pressing the upper die (see FIG. 7B). Therefore, according to the present invention, it is possible to avoid the problem in which the metal material does not sufficiently spread to the molding die, thereby causing defective molding of the projecting portions, such as the heat dissipation fins and the lateral walls (see FIG. 7A). In the heat-dissipating member produced by the producing method of the present invention, it is possible to make the height of the heat dissipation fins to an intended height. As a result, it is possible to suppress a decrease in cooling capacity of the cooling device due to defective molding of the heat dissipation fins.

Also, in a conventional die without projections directly below the positions at which the heat dissipation fins and lateral walls are to be formed, cracking may occur on the back surface corresponding to the positions directly below the heat dissipation fins and the lateral wall of the molded heat-dissipating member. In contrast, the heat-dissipating member produced by the producing method of the present invention, the recesses are formed at positions corresponding to the positions directly below the heat dissipation fins and the lateral walls. Therefore, in the heat-dissipating member produced by the producing method of the present invention, since portions to which cracking may occur are eliminated, possibility of occurrence of cracking can be reduced.

The method for producing a heat-dissipating member of the present invention described above uses impact molding. The method for producing a heat-dissipating member of the present invention is not necessarily limited to the method that uses impact molding. That is, the method for producing a heat-dissipating member of the present invention may use forging and comprise: positioning a metal material on a lower die provided with projections corresponding to positions at which projecting portions to be provided on the heat-dissipating member are to be formed; and molding the metal material by pressing an upper die with recesses for molding the projecting portions against the lower die on which the metal material is positioned, in a manner such that the recesses correspond to the projections on the lower die.

Here, forging is a kind of plastic forming method of metal, which is a processing method for enhancing the strength of a metal by applying pressure to the metal with a hammer or the like to eliminate voids inside the metal, refine crystals and align the direction of the crystals, and forming the metal into a desired shape. Forging, for example, includes cold forging, warm forging, impact molding or the like. Impact molding is sometimes classified as a type of cold forging.

The cooling device according to the present invention may be a cooling device for cooling a heating element, and comprise a coolant storage portion, a coolant passing through an inside of the coolant storage portion. The coolant storage portion may comprise a heat-dissipating member having a contact surface with the heating element. The heat-dissipating member may comprise: a plurality of projecting heat dissipation fins formed on a surface opposite to the contact surface with the heating element; and recesses at least formed at positions in the contact surface corresponding to positions at which the heat dissipation fins are formed.

The heat-dissipating member provided in the cooling device of the present invention can reduce variations in shape of the heat dissipation fins, and form each of the heat dissipation fins to have a desired height. Therefore, in the cooling device of the present invention, desired heat dissipation performance can be maintained. As a result, it is possible to increase cooling efficiency. In addition, the heat-dissipating member provided in the cooling device of the present invention can be produced by the producing method of the present invention. Note that the method for producing the heat-dissipating member provided in the cooling device of the present invention is not particularly limited.

### BRIEF DESCRIPTION OF THE DRAWINGS

FIG. 1 is a perspective view of a cooling device according to an embodiment of the present invention.
FIG. 2A is a top view showing a first member (heat-dissipating member) constituting a coolant storage portion of the cooling device shown in FIG. 1, and FIG. 2B is a cross-sectional view taken along a line IIB-IIB of the first member shown in FIG. 2A.
FIG. 3 is a perspective view showing the first member shown in FIG. 2A.
FIG. 4 is a perspective view showing a back surface of the first member shown in FIG. 2A.
FIG. 5 is a cross-sectional view showing a die for producing the first member (heat-dissipating member).
FIG. 6 is a cross-sectional view showing another example of a die for producing the first member (heat-dissipating member).
FIG. 7A is a diagram for explaining a case of producing the heat-dissipating member by a conventional producing method, and FIG. 7B is a diagram for explaining a case of producing the heat-dissipating member by a producing method of the present invention.

### EXPLANATION OF REFERENCE NUMERALS

10 ... cooling device, 11 ... first member (heat-dissipating member) of a coolant storage portion, 11a ... back surface (of a coolant storage portion), 12 ... second member (lid for coolant storage) of the coolant storage portion, 13a ... coolant inlet pipe, 13b ... coolant outlet pipe, 14 ... bottom plate, 15 ... lateral wall, 20 ... coolant storage portion, 21 ... heat dissipation fins, 22 ... recess, 23 ... groove, 30 ... die (for producing a heat-dissipating member), 31 ... upper die (upper mold), 32 ... lower die (lower mold), 31a ... recess (for molding a heat dissipation fin), 31b ... recess (for molding a lateral wall), 32a ... projection (for molding a recess directly below a heat dissipation fin), 32b ... projection (for molding a recess directly below a lateral wall), 40 ... die (for producing a heat-dissipating member), 41 ... upper die (upper mold), 42 ... lower die (lower mold), 41a ... recess (for molding a heat dissipation fin), 41b ... recess (for molding a lateral wall), 41c ... curved surface, 42a ... projection (for molding a recess directly below a heat dissipation fin), 42b ... projection (for molding a recess directly below a lateral wall)

### MODE FOR CARRYING OUT THE INVENTION

Hereinafter, an embodiment of the present invention will be described with reference to the drawings.

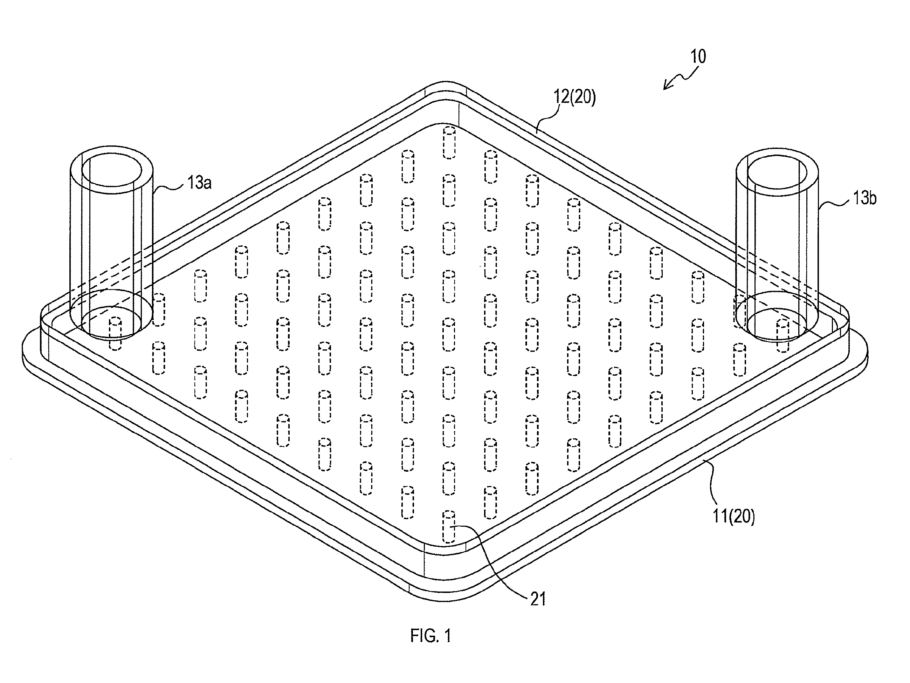

In the present embodiment, description will be given by taking as an example a cooling device for cooling a computer component as a heating element mounted on an automobile. A cooling device 10 of the present embodiment comprises a coolant storage portion 20, as shown in FIG. 1. The cooling device 10 comprises a coolant inlet pipe 13a, and a coolant outlet pipe 13b. In the cooling device 10, a coolant such as cooling water, flows from the coolant inlet pipe 13a into the coolant storage portion 20, and, after passing through the coolant storage portion 20, is discharged from the coolant outlet pipe 13b. The heating element to be cooled (not shown) is positioned to contact a back surface of the coolant storage portion 20 shown in FIG. 1. The heating element is cooled due to heat exchange with the cooling water flowing through the coolant storage portion 20. That is, the back surface of the coolant storage portion 20 is a contact surface with the heating element.

The coolant storage portion 20 of the cooling device 10 comprises a first member 11 and a second member 12. The first member 11 has a plurality of heat dissipation fins (projecting portions provided on the heat-dissipating member) 21. In addition, the first member 11 is provided with the contact surface with the heating element on the back surface, and functions as a heat-dissipating member. The second member functions as a lid for coolant storage. The first member 11 and the second member 12 are sealed by using a connecting member such as a bolt (not shown) in a manner to have an interior space. Thereby, it is possible to flow the coolant into the interior space formed by the first member 11 and the second member. The first member 11 and the second member are made of a metal material including, for example, aluminum. The material of the first member 11 and the second member is not limited to aluminum, and may be other metal materials.

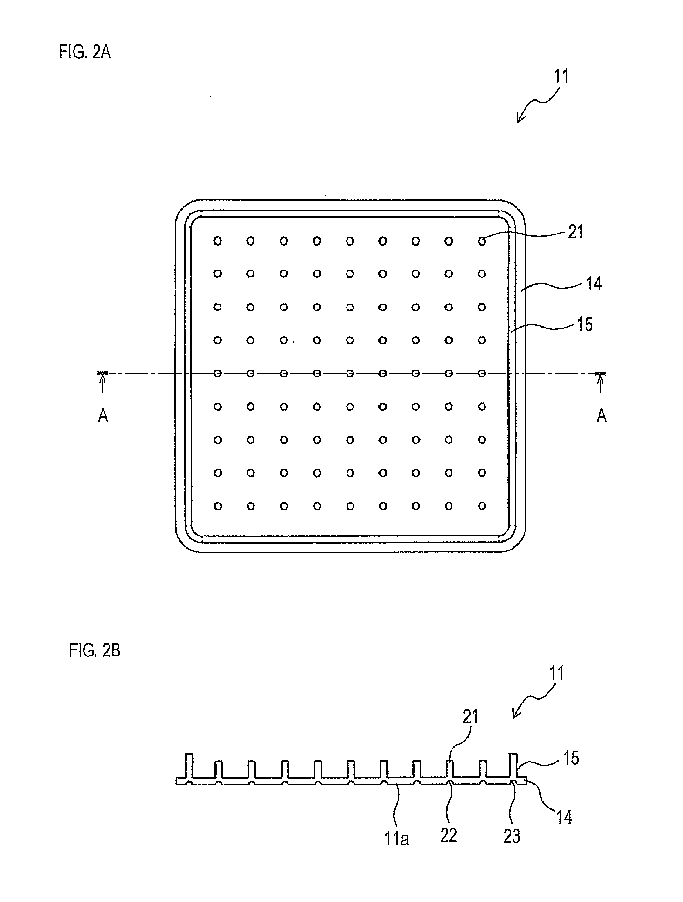

Referring to FIGS. 2A to 4, a specific configuration of the first member 11 as the heat-dissipating member will be described.

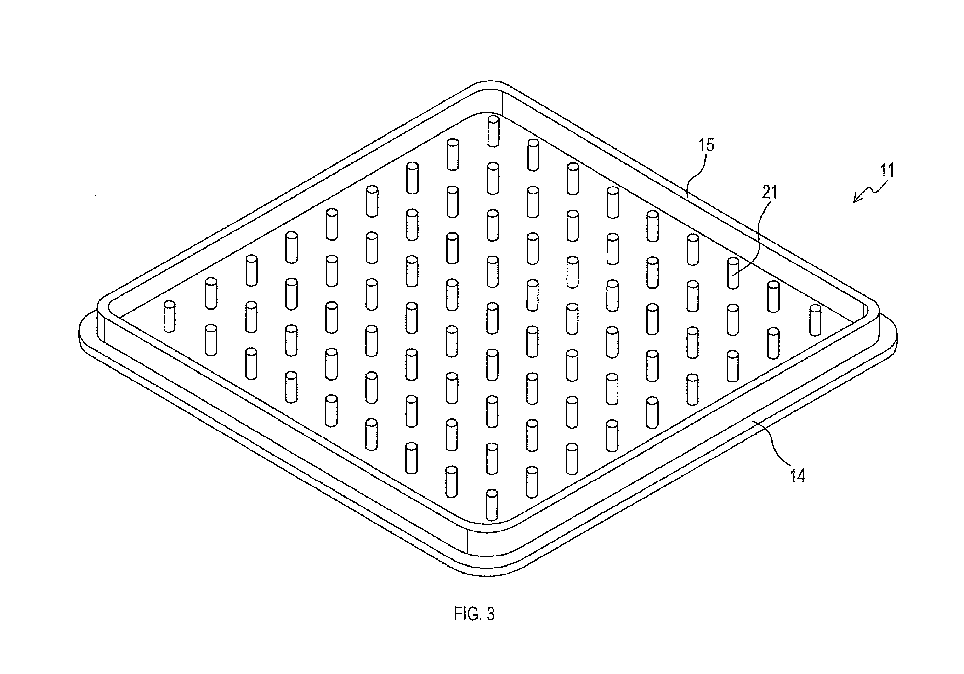

As shown in FIGS. 2A and 3, the first member 11 comprises a rectangular bottom plate 14, and lateral walls (projecting portions provided in the heat-dissipating member) 15 standing to form a rectangle near edges on a surface of the bottom plate 14. Inside a space enclosed by the lateral walls 15, a plurality of heat dissipation fins 21 are arranged in vertical and horizontal alignment on the surface of the bottom plate 14. In this embodiment, the heat dissipation fins 21 are elongated cylindrical projections. However, the present invention is not limited to such a configuration. The heat dissipation fins 21 may be deformed into various shapes such as a prismatic shape, with the intention of, for example, improving heat dissipation. Further, in the present embodiment, the plurality of heat dissipation fins 21 are arranged at substantially equal vertical and horizontal intervals. The present invention is not limited to such a configuration. How to arrange the heat dissipation fins can be appropriately changed as desired.

FIG. 2B shows a cross-sectional configuration of the first member 11 shown in FIG. 2A, taken by a line IIB-IIB. As shown in FIG. 2B, the first member 11 has substantially hemispherical recesses 22, and grooves 23 with a substantially semicircular cross section, on a back surface 11a of the bottom plate 14.

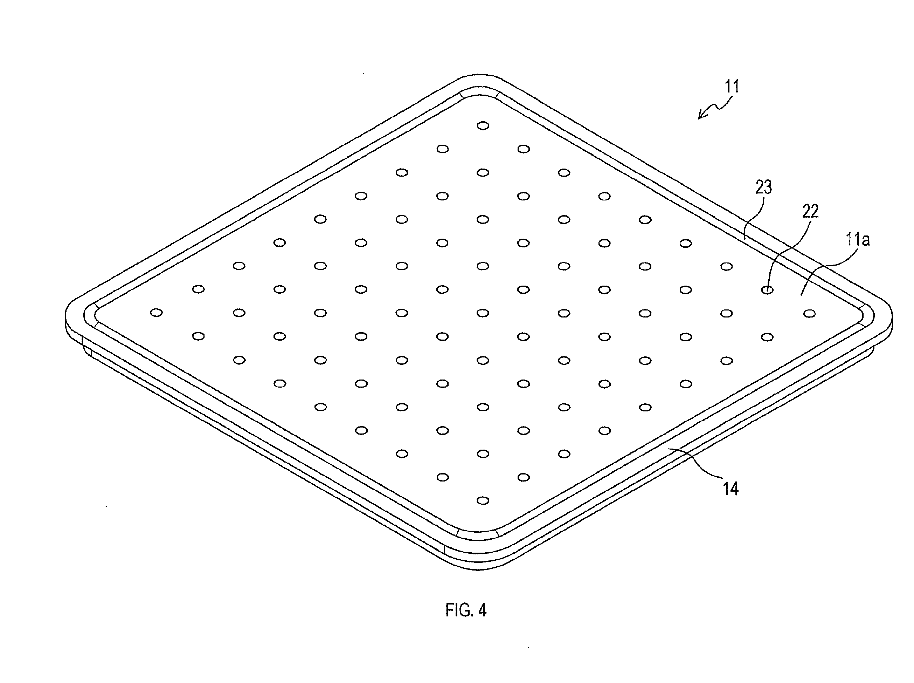

As shown in FIGS. 2B and 4, the plurality of recesses 22 are provided so as to correspond to the heat dissipation fins 21, at portions directly below positions at which the heat dissipation fins 21 are formed. Further, as shown in FIGS. 2B and 4, the grooves 23 are provided along the lateral walls 15, at portions directly below positions at which the lateral walls 15 are formed.

In the cooling device 10 of the present embodiment, the back surface 11a of the coolant storage portion 20 (in other words, the back surface 11a of the bottom plate 14) has the contact surface with the heating element. The heating element disposed in contact with the back surface 11a is cooled by the cooling water passing through the coolant storage portion 20. The heat dissipation fins 21 are provided on a surface opposite to the back surface 11a of the bottom plate 14. Thereby, heat transferred from the heating element relative to the first member 11 can be further efficiently dissipated to the cooling water. Therefore, with the heat dissipation fins 21, it is possible to improve cooling efficiency.

The first member 11 of the cooling device 10 of the present embodiment may be produced using a method for producing a heat-dissipating member to be described later. In this case, the recesses 22 are provided directly below the heat dissipation fins 21, and the grooves 23 are provided directly below the lateral walls 15. Thereby, variations in shape of each of the heat dissipation fins 21 can be decreased. Also, each of the heat dissipation fins 21 is formed to a desired height. Therefore, it is possible to maintain desired heat dissipation performance.

In this embodiment, only the first member 11 has been described as an example of a configuration that functions as a heat-dissipating member having the heat dissipation fins. However, the present invention is not limited to this configuration. If not only the first member but the second member have a contact surface with an electronic component, etc. to be cooled, the heat dissipation fins and the recesses similar to those of the first member may also be formed in the second member.

In this embodiment, a case has been described in which the coolant of the cooling device is water, as an example. The present invention is not necessarily limited to this. Any coolant commonly used as a coolant for a cooling device can be used by appropriate selection.

Now, the method for producing a heat-dissipating member (first member 11) provided in the cooling device 10 will be described. The method for producing a heat-dissipating member described here is an example of a method for producing a heat-dissipating member of the present invention.

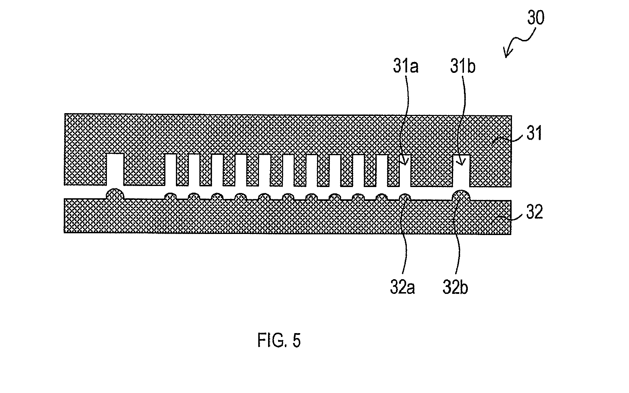

The method for producing a heat-dissipating member of the present embodiment is performed using impact molding which is a kind of forging. FIG. 5 shows a die 30 for impact molding used in production of a heat-dissipating member. The die 30 is constituted by an upper die (upper mold) 31 and a lower die (lower mold) 32. The die 30 has a shape for molding the heat-dissipating member (first member 11) of the cooling device 10 by combining the upper die 31 and the lower die 32 together.

The upper die 31 is a die for molding the surface side of the first member 11. The upper die 31 has recesses 31a for molding the heat dissipation fins and recesses 31b for molding the lateral walls. Note that, in the die 30 shown in FIG. 5, although eleven recesses 31a are provided for molding the heat dissipation fins, this number can be arbitrarily determined in accordance with the shape of the intended heat-dissipating member.

The lower die 32 is a die for molding the back surface 11a side of the first member. The lower die 32 has projections 32a for molding the recesses 22 provided directly below the positions at which the heat dissipation fins 21 of the first member 11 are to be formed. The lower die 32 also has projections 32b for molding the grooves 23 provided directly below the positions at which the lateral walls 15 are to be formed.

The upper die 31 and the lower die 32 are made of a material that is generally used as a die material for impact molding.

The first member 11 is produced by impact molding, using the die 30 (upper die 31 and lower die 32) constituted as described above.

In this producing method, first, on the lower die 32 constituted as described above, a metal material (also referred to as slag) is positioned as a raw material of the first member 11. Then, the upper die 31 constituted as described above is pressed against the lower die 32 on which the metal material is positioned, so as to mold the first member 11. In this step of pressing, punching of the upper die 31 is carried out such that the recesses 31a of the upper die 31 correspond to the projections 32a of the lower die 32, and that recesses 31b of the upper die 31 correspond to the projections 32b of the lower die 32.

With the steps described above, the first member (heat-dissipating member) 11 can be produced in which a plurality of the heat dissipation fins 21 and the lateral walls 15 are formed on the surface, and in which the recesses 22 corresponding to the heat dissipation fins 21 and the grooves 23corresponding to the lateral walls 15 are formed on the back surface 11 a.

With the method described above, it is possible to produce a heat-dissipating member of the cooling device 10. For methods for producing members other than the heat-dissipating member in the cooling device 10, generally known methods as methods for producing a cooling device may be employed. Therefore, descriptions thereof are omitted here.

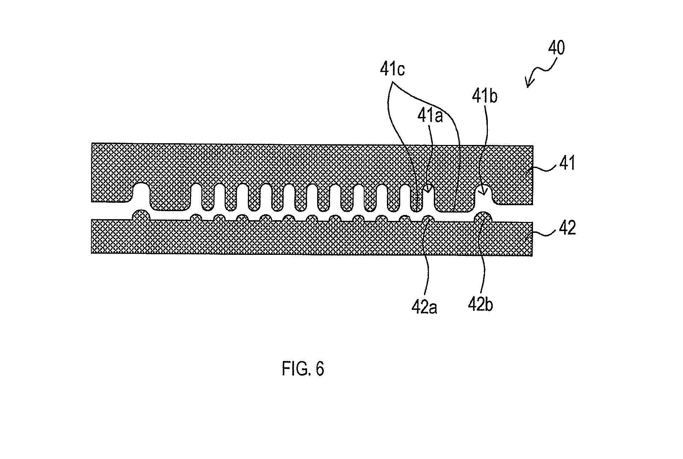

Note that the shape of the die used to produce the heat-dissipating member is not limited to the shape shown in FIG. 5. FIG. 6 shows another example of the shape of the die for producing the heat-dissipating member.

A die 40 shown in FIG. 6 is constituted by an upper die (upper mold) 41 and a lower die (lower mold) 42. The upper die 41 is a die for molding the surface side of the first member 11. The upper die 41 has recesses 41a for molding the heat dissipation fins and recesses 41b for molding the lateral walls. The lower die 42 is a die for molding the back surface 11a side of the first member. The lower die 42 has projections 42a for molding the recesses 22 to be provided directly below the positions at which the heat dissipation fins 21 are to be formed. The lower die 42 has projections 42b for molding the grooves 23 to be provided directly below the positions at which the lateral walls 15 are to be formed.

The above die 40 has the same configuration as that of the die 30. However, in the die 40, distal ends of the projecting portions between the two adjacent recesses 41a of the upper die 41 and between the recesses 41a and the recesses 41b have a curved shape 41c. Such a deformation in shape of the die can be implemented as required, in order to form the heat dissipation fins into a desired shape.

According to the method for producing a heat-dissipating member of the present invention, since the projections are provided in the lower die 32 (or the lower die 42) corresponding to the positions at which the heat dissipation fins 21 and the lateral walls 15 are to be formed, it is possible to spread the metal material to the distal ends of the recesses for molding the heat dissipation fins and the lateral walls upon pressing the upper die 31, as shown in FIG. 7B. Therefore, the heat-dissipating member produced by the method for producing a heat-dissipating member of the present invention is molded into a shape that is closely adapted to the shape of the die. Therefore, it is possible to form the heat dissipation fins to an intended height. As a result, it is possible to suppress a decrease in cooling capacity of the cooling device due to defective molding of the heat dissipation fins. Also, it is possible to reduce variations in height of the heat dissipation fins.

For the purpose of obtaining the effect as described above, the die used in the method for producing a heat-dissipating member of the present invention comprises at least projections at portions corresponding to the lower die, that is, directly below the heat dissipation fins of the heat-dissipating member. However, the shape of the projections 32a and 32b (or, the projections 42a and 42b) is not limited to a shape with a semicircular (i.e., semi-spherical or semi-cylindrical) cross section as shown in FIGS. 5 and 6. Also, the die 30 and 40 described in this embodiment are configured to have one projection for each heat dissipation fin. However, the present invention is not limited to such a configuration. It is sufficient that at least a projection is formed directly below the heat dissipation fin. Thus, for example, it is also possible to provide one linear projection for a plurality of the heat dissipation fins arranged in a row. Also, depending on size and shape of the recesses for molding provided on the upper die, it is possible to change the shape and size of the projections formed on the lower die as required. For example, the inner peripheral surface of the recesses of the upper die 41 may have a shape with a circular arc cross section, so that the distal ends of the heat dissipation fins 21 and the lateral walls 15 of the cooling device have a chamfered shape, as shown in FIG. 6.

The method for producing a heat-dissipating member of the present invention can be also applied to the production of other metal components that uses impact molding. In this case, depending on the shape of the intended metal component, a projection is formed in a predetermined portion of the lower die corresponding to a position at which the projecting portion of the metal component is formed. Thereby, it is possible to spread the metal material to every corner of the upper die, and improve moldability of the metal component.

In the method for producing a heat-dissipating member of the present invention, the configuration has been described in which the first member 11 comprises the rectangular bottom plate 14 and the lateral walls 15 standing to form a rectangle near the edges on the surface of the bottom plate 14. However, the present invention is not limited to this. The bottom plate 14 may have, for example, a polygonal, circular, or oval shape, other than the rectangular shape. In this case, the lateral walls 15 may stand near the edges on the surface near the bottom plate 14.

In the present embodiment, as an example of the method for producing a heat-dissipating member of the present invention, the method using impact molding has been described. However, the present invention is not limited to this. That is, the method for producing a heat-dissipating member of the present invention may be carried out using other kinds of forging. Other kinds of forging include cold forging, warm forging, hot forging and the like.

As above, an embodiment of the present invention has been described. The present invention is not at all limited to the embodiment described above, and can be practiced in various forms without departing from the scope of the invention. Other configurations obtained by appropriate combination of different embodiments are included in the scope of the present invention.

## Claims

1. A method for producing a heat-dissipating member using impact molding, the method comprising:
positioning a metal material on a lower die provided with projections corresponding to positions at which projecting portions to be provided in the heat-dissipating member are to be formed; and
molding the metal material by pressing an upper die having recesses for molding the projecting portions against the lower die on which the metal material is positioned, in a manner such that the recesses correspond to the projections on the lower die.

2. A cooling device for cooling a heating element, comprising a coolant storage portion through which a coolant passes,
the coolant storage portion comprising a heat-dissipating member having a contact surface with the heating element,
the heat-dissipating member comprising:
a plurality of projecting heat dissipation fins formed on a surface opposite to the contact surface with the heating element; and
recesses at least formed at positions in the contact surface corresponding to positions at which the heat dissipation fins are formed.
